(19) Europäisches Patentamt / European Patent Office / Office européen des brevets

(11) **EP 3 598 151 B1**

(12) **EUROPÄISCHE PATENTSCHRIFT**

(45) Veröffentlichungstag und Bekanntmachung des Hinweises auf die Patenterteilung:
**01.05.2024  Patentblatt 2024/18**

(21) Anmeldenummer: **19182765.8**

(22) Anmeldetag: **27.06.2019**

(51) Internationale Patentklassifikation (IPC):
**G01R 27/02** *(2006.01)*     **G01R 27/26** *(2006.01)*
**G01R 31/52** *(2020.01)*

(52) Gemeinsame Patentklassifikation (CPC):
**G01R 27/025; G01R 27/2605; G01R 31/52;**
G01R 19/0084

(54) **VERFAHREN UND VORRICHTUNG ZUR BESTIMMUNG DER AUFTEILUNG EINES GESAMT-ISOLATIONSWIDERSTANDS UND DER AUFTEILUNG EINER GESAMT-NETZABLEITKAPAZITÄT IN EINEM UNGEERDETEN STROMVERSORGUNGSSYSTEM**

METHOD AND DEVICE FOR DETERMINING THE DISTRIBUTION OF A TOTAL ISOLATION RESISTANCE AND THE DISTRIBUTION OF A TOTAL POWER LINE CAPACITY IN AN UNEARTHED POWER SYSTEM

PROCÉDÉ ET DISPOSITIF DE DÉTERMINATION DE LA RÉPARTITION D'UNE RÉSISTANCE TOTALE D'ISOLEMENT ET DE LA RÉPARTITION D'UNE CAPACITÉ TOTALE DE DÉRIVATION DU RÉSEAU DANS UN SYSTÈME D'ALIMENTATION EN COURANT ISOLÉ TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.07.2018  DE 102018117296**

(43) Veröffentlichungstag der Anmeldung:
**22.01.2020  Patentblatt 2020/04**

(73) Patentinhaber: **Bender GmbH & Co. KG**
**35305 Grünberg (DE)**

(72) Erfinder:
• **HACKL, Dieter**
**35463 Fernwald (DE)**

• **SCHÄFER, Oliver**
**35305 Grünberg (DE)**
• **BECKER, Pascal**
**35305 Grünberg (DE)**
• **SCHEPP, Karl**
**35447 Reiskirchen (DE)**

(74) Vertreter: **advotec.**
**Patent- und Rechtsanwaltspartnerschaft Tappe mbB**
**Georg-Schlosser-Straße 6**
**35390 Gießen (DE)**

(56) Entgegenhaltungen:
**DE-A1-102014 204 038     DE-A1-102015 008 831**

**Beschreibung**

Die Erfindung betrifft ein Verfahren zur Bestimmung einer Aufteilung eines Gesamt-Isolationswiderstands und einer Gesamt-Netzableitkapazität in einem ungeerdeten Stromversorgungssystem.

Weiterhin betrifft die Erfindung eine Vorrichtung zur Durchführung der genannten Verfahren.

Bei erhöhten Anforderungen an die Betriebs-, Brand- und Berührungssicherheit elektrischer Anlagen kommt die Netzform eines ungeerdeten Stromversorgungssystems zum Einsatz, die auch als isoliertes Netz (isolé terre - IT) oder als IT-(Stromversorgungs-)System bezeichnet wird. Bei dieser Art des Stromversorgungssystems sind die aktiven Teile von dem Erdpotential - gegenüber Erde - getrennt. Der Vorteil dieser Netze liegt darin, dass bei einem Isolationsfehler, wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Stromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte.

Unter der Voraussetzung, dass der Isolationszustand des ungeerdeten Stromversorgungssysteme kontinuierlich von einem Isolationsüberwachungsgerät überwacht wird, kann das ungeerdete Stromversorgungssystem auch bei einem aufgetretenen ersten Fehler ohne vorgeschriebene Zeitlimitierung weiter betrieben werden.

Zur Überwachung des Isolationswiderstands werden Isolationsüberwachungsgeräte eingesetzt. Aus dem Stand der Technik bekannte Isolationsüberwachungsgeräte nach der Produktnorm IEC 61557-8 bestimmen den Isolationswiderstand des gesamten IT-Systems gegen Erde. Das Isolationsüberwachungsgerät wird zwischen den aktiven Leitern einerseits und Erde andererseits angeschlossen und überlagert dem Netz eine Messspannung. Bei Auftreten eines Isolationsfehlers schließt sich der Messkreis zwischen Netz und Erde über den Isolationsfehler, sodass sich ein dem Isolationsfehler proportionaler Messstrom einstellt. Dieser Messstrom verursacht an einem Messwiderstand in dem Isolationsüberwachungsgerät einen entsprechenden Spannungsabfall, der von der Elektronik ausgewertet wird und bei Überschreiten eines voreinstellbaren Grenzwertes zu einer Alarmmeldung führt.

Normgemäß ausgeführte Isolationsüberwachungsgeräte berücksichtigen dabei symmetrisch auf alle aktiven Leiter verteilte ohmsche Ableitungen als Isolationsfehler genauso wie unsymmetrisch, beispielsweise an einem einzelnen aktiven Leiter auftretende Isolationsfehler.

Auf dem Markt verfügbare Isolationsüberwachungsgeräte besitzen neben der Bestimmung des Gesamt-Isolationswiderstands zusätzlich die Funktionalität, die Gesamt-Netzableitkapazität des ungeerdeten Stromversorgungssystems gegen Erde zu bestimmen. Analog zu dem Gesamt-Isolationswiderstand, welcher den ohmschen Anteil der Gesamt-Netzableitimpedanz darstellt, stellt die Gesamt-Netzableitkapazität den kapazitiven Anteil der Gesamt-Netzableitimpedanz gegen Erde dar. Die Gesamt-Netzableitkapazität ist dabei die Summe aller Netzableitkapazitäten gegen Erde wie zum Beispiel kapazitive Leitungsbeläge von aktiven Leitern oder Funkentstörkondensatoren in den angeschlossenen Betriebsmitteln.

Nicht zufriedenstellend gelöst ist bislang die Aufgabe, die Verteilung von Isolationswiderstandswerten und Netzableitkapazitätswerten für einzelne aktive Leiter gegen Erde selektiv zu ermitteln. Zwar können mit Hilfe der Isolationsüberwachungsgeräte der Gesamt-Isolationswiderstand und die Gesamt-Netzableitkapazität ermittelt werden, jedoch erweist sich die Bestimmung der Aufteilung des Gesamt-Isolationswiderstandes bzw. der Gesamt-Netzableitkapazität auf die einzelnen aktiven Leiter als problematisch.

In ungeerdeten reinen Gleichspannungssystemen ist es möglich, über eine Messung einer Verlagerungsspannung eine Aussage über die Aufteilung des Gesamt-Isolationswiderstands auf die aktiven Leiter und gegen Erde zu ermitteln. Eine Bestimmung der Aufteilung der Gesamt-Netzableitkapazität auf die aktiven Leiter gegen Erde ist bislang in Isolations-überwachungsgeräten, die der Produktnorm IEC 61557-8 entsprechen, nicht implementiert.

So zeigt die Offenlegungsschrift DE 10 2015 008 831 A1 eine Asymmetrie-Bestimmung des Isolationswiderstands in einem Kfz-Hochvolt-Bordnetz. Die Ermittlung des Asymmetriewertes erfolgt dabei durch Auswertung gemessener Spannungswerte, nämlich dem Plus-Isolationsspannungswert gegen Masse und den Minus-Isolationsspannungswert gegen Masse in dem DC-Teilsystem, wobei asymmetrische Fehler in dem AC-Teilsystem ausgeschlossen werden.

In ungeerdeten ein- oder mehrphasigen Wechselspannungs-Stromversorgungssystemen ist die Bestimmung der Aufteilung des Gesamt-Isolationswiderstands nur durch eine Verlagerungsspannungsmessung alleine nicht möglich, da die Verlagerungsspannungen auch entscheidend von der Größe und der Verteilung der Netzableitkapazitäten zwischen den aktiven Leitern gegen Erde abhängen.

Häufig wird in ungeerdeten Stromversorgungssystemen eine symmetrische Lage des ungeerdeten Systems gegen Erde, eine symmetrische Last der Leiter und eine Minimierung von Schutzleiterströmen angestrebt, um eine Belastung der elektrischen Isolierung und der elektrischen Komponenten gegen Erde zu minimieren. Bei der Systemplanung und bei der Systemerrichtung wird dies meistens berücksichtigt.

Werden jedoch im Laufe des Netzbetriebs Änderungen an dem ungeerdeten Stromversorgungssystem vorgenommen oder kommt es durch Alterung oder vergleichbare Umwelteinflüsse zu einer Verlagerung des symmetrischen Zustands hin zu unsymmetrischen Zuständen, so ist eine frühzeitig vorliegende Information über diese Veränderung wichtig, um vorbeugend Wartungsmaßnahmen einleiten zu können. Infolge dieser Veränderungen kann von einer symmetrischen Aufteilung des Gesamt-Isolationswiderstands und der Gesamt-Netzableitkapazität auf die aktiven Leiter nicht ausgegangen werden.

Der vorliegenden Erfindung, die durch die unabhängigen Ansprüche definiert ist, liegt somit die Aufgabe zugrunde, ein Verfahren und eine Vorrichtung vorzuschlagen, welche in der Lage sind, sowohl die Aufteilung des Gesamt-Isolationswiderstands als auch der Gesamt-Netzableitkapazität auf die einzelnen aktiven Leiter eines ungeerdeten Gleichspannungs- oder Wechselspannungs-Stromversorgungssystems zu bestimmen.

Diese Aufgabe wird bezogen auf die Aufteilung eines Gesamt-Isolationswiderstands in einem ungeerdeten Stromversorgungssystem mit aktiven Leitern, zwischen denen jeweils eine Leiter-Leiter-Spannung auftritt, ausgehend von einer zuvor durchgeführten Bestimmung des Gesamt-Isolationswiderstands durch folgende weitere Verfahrensschritte gelöst: Messen von Verlagerungsspannungen zwischen jeweils einem der aktiven Leiter und Erde sowie Ermitteln eines Widerstands-Aufteilungsfaktors, welcher die Aufteilung des Gesamt-Isolationswiderstands in auf die aktiven Leiter bezogene Teil-Isolationswiderstände beschreibt, in Abhängigkeit von mindestens einem der Parameter Amplitude, Frequenz, Phase der gemessenen Verlagerungsspannungen.

Die grundlegende Idee der vorliegenden Erfindung besteht darin, ausgehend von einem bekannten Wert für den Gesamt-Isolationswiderstand des ungeerdeten Stromversorgungssystems, welcher beispielsweise von einem normativ vorgeschriebenen Isolationsüberwachungsgerät ermittelt wurde, aus Messungen von Verlagerungsspannungen zwischen jeweils einem aktiven Leiter des ungeerdeten Stromversorgungssystems und Erde zu bestimmen, wie sich der Gesamt-Isolationswiderstand in Teil-Isolationswiderstände auf die aktiven Leiter des ungeerdeten Stromversorgungssystems aufteilt.

Aus der Messung der Verlagerungsspannungen, insbesondere aus deren zeitlichen Amplitudenverläufen, daraus abgeleiteten Frequenz- und/oder Phasenmessungen wird ein Widerstands-Aufteilungsfaktor ermittelt, welcher die Aufteilung des Gesamt-Isolationswiderstands beschreibt.

In einem ungeerdeten ein- oder mehrphasigen AC-Stromversorgungssystem wird der Widerstands-Aufteilungsfaktor aus dem Verhältnis der Amplituden der Verlagerungsspannungen unter Einbeziehung der Frequenz und der Phasenlagen der Verlagerungsspannungen ermittelt.

Durch die fortlaufenden, inhärent vorhandenen Spannungsänderungen in einem Wechselspannungs-Stromversorgungssystem können bereits die notwendigen Informationen zur Bestimmung der Aufteilung des Gesamt-Isolationswiderstands abgeleitet werden. Eine weitere Spannungsänderung, beispielsweise durch eine Laständerung, ist hier keine notwendige Voraussetzung, kann aber auch in vorteilhafter Weise genutzt werden. Da in einem Stromversorgungssystem unvermeidlich Netzableitkapazitäten (Imaginärteil der komplexwertigen Netzableitimpedanz) vorhanden sind, die den Wert der Netzableitimpedanz mitbestimmen, wird der Widerstands-Aufteilungsfaktor für den Gesamt-Isolationswiderstand (Realteil der komplexwertigen Netzableitimpedanz) aus dem Verhältnis der Amplituden der Verlagerungsspannungen unter Einbeziehung der Frequenz und der Phasenlagen der Verlagerungsspannungen ermittelt.

Die Bestimmung einer Aufteilung einer Gesamt-Netzableitkapazität in einem ungeerdeten Stromversorgungssystem mit aktiven Leitern, zwischen denen jeweils eine Leiter-Leiter-Spannung auftritt, erfolgt in Verbindung mit einer vorherigen Bestimmung der Gesamt-Netzableitkapazität in folgenden Verfahrensschritten: Messen von Verlagerungsspannungen zwischen jeweils einem der aktiven Leiter und Erde sowie Ermitteln eines Kapazitäts-Aufteilungsfaktors, welcher die Aufteilung der Gesamt-Netzableitkapazität in auf die aktiven Leiter bezogene Teil-Netzableitkapazitäten beschreibt, in Abhängigkeit von mindestens einem der Parameter Amplitude, Frequenz, Phase der gemessenen Verlagerungsspannungen.

In Analogie zur Grundidee bei der Bestimmung der Aufteilung des Gesamt-Isolationswiderstands beruht auch die Bestimmung der Aufteilung der Gesamt-Netzableitkapazität darauf, dass zunächst Verlagerungsspannungen zwischen jeweils einem aktiven Leiter des ungeerdeten Stromversorgungssystems und Erde gemessen werden und dann, basierend auf einer Auswertung der zeitlichen Amplitudenverläufe, daraus abgeleiteten Frequenz- und/oder Phasenmessungen ein Kapazitäts-Aufteilungsfaktor ermittelt wird, welcher die Aufteilung der Gesamt-Netzableitkapazität beschreibt.

Vorteilhafterweise wird in einem ungeerdeten DC-Stromversorgungssystem der Kapazitäts-Aufteilungsfaktor aus der Dauer eines durch die Amplitudenänderung der Leiter-Leiter-Spannung verursachten Einschwingvorgangs der jeweiligen Verlagerungsspannung ermittelt.

Die durch ein externes Ereignis, beispielsweise einen Schaltervorgang in Form einer Laständerung, verursachte Amplitudenänderung der Leiter-Leiter-Spannung führt zu einer beobachtbaren Amplitudenänderung der an dem jeweiligen aktiven Leiter messbaren Verlagerungsspannung. Aus dem Verhältnis der Dauer der Einschwingvorgänge bzw. deren Zeitkonstanten kann der Kapazitäts-Aufteilungsfaktor der Gesamt-Netzableitkapazität auf die Teil-Netzableitkapazitäten des jeweiligen aktiven Leiters ermittelt werden.

Mit Vorteil wird in einem ungeerdeten ein- oder mehrphasigen Wechselspannungs-Stromversorgungssystem der Kapazitäts-Aufteilungsfaktor aus dem Verhältnis der Amplituden der Verlagerungsspannungen unter Einbeziehung der Frequenz und der Phasenlagen der Verlagerungsspannungen ermittelt.

In einem ungeerdeten ein- oder mehrphasigen Wechselspannungs-Stromversorgungssystem werden die sich fortlaufend ändernden Amplituden, die Frequenz und die Phasenlagen der Verlagerungsspannungen bewertet und daraus der Kapazitäts-Aufteilungsfaktor für die Aufteilung der Gesamt-Netzableitkapazität in Teil-Netzableitkapazitäten auf die aktiven Leiter ermittelt.

Bezogen auf eine Vorrichtung zur Durchführung eines Verfahrens zur Bestimmung einer Aufteilung eines Gesamt-Isolationswiderstands und einer Gesamt-Netzableitkapazität in einem ungeerdeten Stromversorgungssystem wird die Aufgabe basierend auf einem normgemäßen Isolationsüberwachungsgerät zur Bestimmung des Gesamt-Isolationswiderstands und welches zur Bestimmung der Gesamt-Netzableitkapazität ausgeführt ist, dadurch gelöst, dass die Vorrichtung weiter aufweist: Signaleingänge zum Messen von Verlagerungsspannungen und Signalverarbeitungseinheiten zum Ermitteln eines Widerstands-Aufteilungsfaktors, welcher die Aufteilung des Gesamt-Isolationswiderstands in auf die aktiven Leiter bezogene Teil-Isolationswiderstände beschreibt und zum Ermitteln eines Kapazitäts-Aufteilungsfaktors, welcher die Aufteilung der Gesamt-Netzableitkapazität in auf die aktiven Leiter bezogene Teil-Netzableitkapazitäten beschreibt.

Da in ungeerdeten Stromversorgungssystemen zur Isolationsüberwachung die Verwendung eines Isolationsüberwachungsgerätes zwingend vorgeschrieben ist, kann der von dem normgemäßen Isolationsüberwachungsgerät bestimmte Isolationswiderstandswert vorteilhaft genutzt werden, um die erfindungsgemäße Aufteilung dieses Gesamt-Isolationswiderstands in Teil-Isolationswiderstände durchzuführen.

Weiterhin umfasst die Vorrichtung Funktionsblöcke zur Bestimmung der Gesamt-Netzableitkapazität, um auf Basis dieser ermittelten Gesamt-Netzableitkapazität die Teil-Netzableitkapazitäten erfindungsgemäß zu bestimmen.

Dazu weist das erweiterte Isolationsüberwachungsgerät weitere Signaleingänge auf, an denen die Verlagerungsspannungen erfasst werden.

Zur Verarbeitung der erfassten Verlagerungsspannungen sind Signalverarbeitungseinheiten zum Ermitteln des jeweiligen Aufteilungsfaktors des Gesamt-Isolationswiderstands und der Gesamt-Netzableitkapazität vorgesehen.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern. Es zeigen

Fig. 1    eine Anwendung des erfindungsgemäßen Verfahrens in einem ungeerdeten Gleichspannungs-Stromversorgung s system;

Fig. 2    Messungen der Verlagerungsspannungen in dem in Fig. 1 dargestellten ungeerdeten Gleichspannungs-Stromversorgungssystem;

Fig. 3    Anwendung des erfindungsgemäßen Verfahrens in einem ungeerdeten einphasigen Wechselspannungs-Stromversorgungssystem und

Fig. 4    Messungen der Verlagerungsspannungen in dem in Fig. 3 dargestellten einphasigen Wechselspannungs-Stromversorgungssystem.

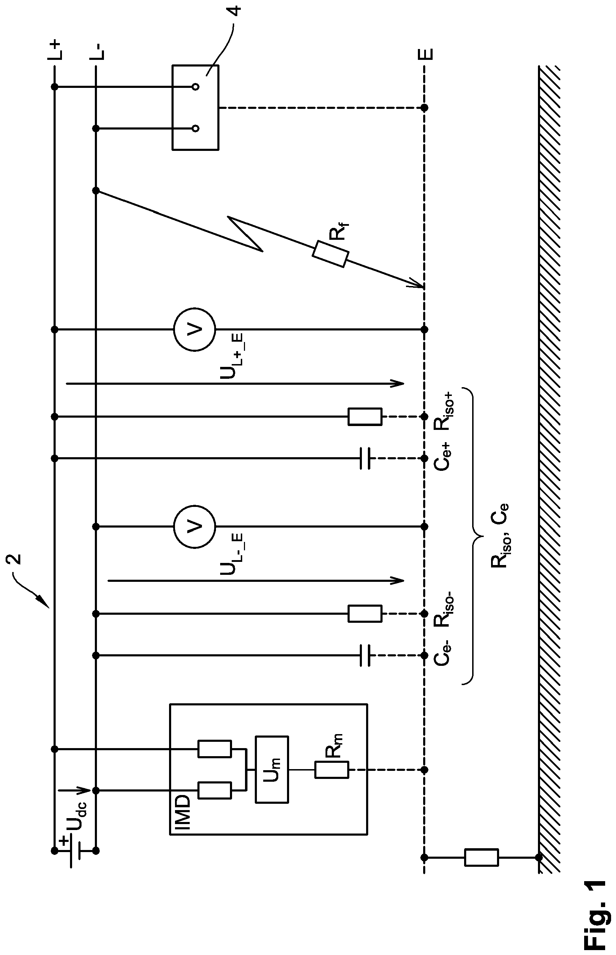

**Fig. 1** zeigt ein ungeerdetes DC-Stromversorgungssystem 2 mit zwei aktiven Leitern L+ und L-. Das DC-Stromversorgungssystem 2 wird von einer Spannungsquelle $U_{dc}$ gespeist, welche eine zwischen die aktiven Leiter L+ und L- geschaltete Last 4 mit Energie versorgt.

Zur Überwachung des Gesamt-Isolationswiderstandes $R_{iso}$ des ungeerdeten DC-Stromversorgungssystems 2 ist ein Isolationsüberwachungsgerät IMD zwischen die aktiven Leiter L+, L- einerseits und Erde (Erdpotential) E andererseits geschaltet, welches dem Stromversorgungssystem 2 eine Messspannung $U_m$ überlagert. Über die den jeweiligen aktiven Leitern L+, L_ zugeordneten und als Ableitwiderstände wirkenden Teil-isolationswiderstände $R_{iso+}$, $R_{iso-}$ sowie über die den jeweiligen aktiven Leitern L+, L- zugeordneten Teil-Netzableitkapazitäten $C_{e+}$, $C_{e-}$ stellt sich ein Messstrom $I_m$ ein, der an einem Messwiderstand $R_m$ des Isolationsüberwachungsgerätes IMD einen entsprechenden Spannungsabfall verursacht, der von dem Isolationsüberwachungsgerät IMD ausgewertet wird. Der so ermittelte Gesamt-Isolationswiderstand $R_{iso}$ ergibt sich aus der Parallelschaltung der Teil-Isolationswiderstände $R_{iso+}$, $R_{iso-}$.

Um eine Aussage über die Aufteilung des Gesamt-Isolationswiderstands $R_{iso}$ in die den jeweiligen aktiven Leitern L+ und L- zugeordneten Teil-Isolationswiderstände $R_{iso+}$, $R_{iso-}$ treffen zu können, werden zusätzlich die Verlagerungsspannungen $U_{L+\_E}$ und $U_{L-\_E}$ gemessen, die sich jeweils zwischen dem aktiven Leiter L+ und Erde bzw. zwischen dem aktiven Leiter L- und Erde E ergeben.

Weiterhin wird eine Gesamt-Netzableitkapazität $C_e$ gemessen, die sich aus der Parallelschaltung der den jeweiligen aktiven Leitern L+, L- zugeordneten Teilableitkapazitäten $C_{e+}$ und $C_{e-}$ ergibt.

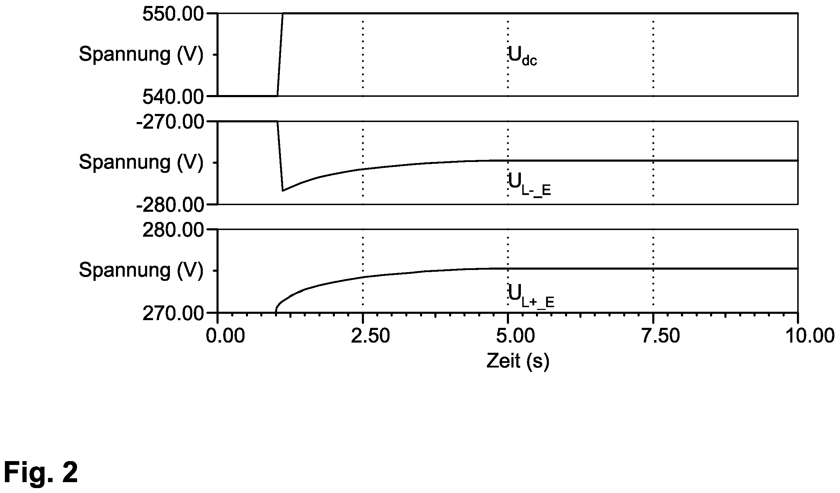

**Fig. 2** zeigt Messungen der Verlagerungsspannungen $U_{L+\_E}$ und $U_{L-\_E}$, die sich als Reaktion auf eine sprungförmige Änderung der Leiter-Leiter-Spannung (Einspeisespannung) $U_{dc}$ ergeben.

Aus einem Maschenumlauf $U_{dc} = U_{L+\_E} - U_{L-\_E}$ ergeben sich bei einem Spannungssprung um 10 Volt von 540 Volt auf 550 Volt die in Fig. 2 dargestellten Verläufe für die Verlagerungsspannungen $U_{L+\_E}$ und $U_{L-\_E}$. Nach Beendigung des Einschwingvorgangs weisen die Verlagerungsspannungen $U_{L+\_E}$ und $U_{L-\_E}$ betragsmäßig jeweils den gleichen Wert von 275 Volt auf, sodass hieraus auf eine symmetrische Verteilung des ermittelten Gesamt-Isolationswiderstands $R_{iso}$ auf die Teil-Isolationswiderstände $R_{iso+}$, $R_{iso-}$ geschlossen werden kann.

Aus dem Verhältnis der beiden Endwerte der Verlagerungsspannungen $U_{L+\_E}$ und $U_{L-\_E}$ an den beiden aktiven Leitern L+, L- lässt sich direkt das Verhältnis des Teil-Isolationswiderstands $R_{iso+}$ des aktiven Leiters L+ zu dem Gesamt-Isolationswiderstand $R_{iso}$ und damit der Widerstands-Aufteilungsfaktor $r_R$ ermitteln.

Allgemein gilt für ein ungeerdetes DC-Stromversorgungssystem mit zwei aktiven Leitern $R_{iso+} = r_R \times R_{iso}$ und

$$R_{iso-} = \left(\frac{1}{r_R - 1} + 1\right) \times R_{iso}$$

.

Aus der Dauer eines durch die Amplitudenänderung der Leiter-Leiter-Spannung $U_{dc}$ verursachten Einschwingvorgangs der jeweiligen Verlagerungsspannung $U_{L+\_E}$, $U_{L-\_E}$, bzw. der aus dem Verlauf der Einschwingvorgänge gewonnenen Zeitkonstanten erhält man den Kapazitäts-Aufteilungsfaktor $r_C$ der Teil-Netzableitkapazität $C_{e+}$ des aktiven Leiters L+ zur Gesamt-Netzableitkapazität $C_e$ des Stromversorgungssystems.

Für die Teil-Netzableitkapazitäten $C_{e+}$, $C_{e-}$ folgt somit: $C_{e+} = r_C \times C_e$ und $C_{e-} = (1 - r_C) \times C_e$.

Beispielsweise ergeben sich mit einem Widerstands-Aufteilungsfaktor $r_R$ von 25 und einem ermittelten Gesamt-Isolationswiderstand $R_{iso}$ von 19,2 KΩ aus den oben aufgeführten Formeln die Aufteilung $R_{iso+}$ = 480 KΩ und $R_{iso-}$ = 20 KΩ.

In gleicher Weise ergibt sich beispielsweise für einen Wert von 0,25 für den Kapazitäts-Aufteilungsfaktor rc und einer ermittelten Gesamt-Netzableitkapazität $C_e$ von 40 μF die Aufteilung von $C_{e+}$ = 10 μF und $C_{e-}$ = 30 μF für die Teil-Netzableitkapazitäten der aktiven Leiter L+ und L-.

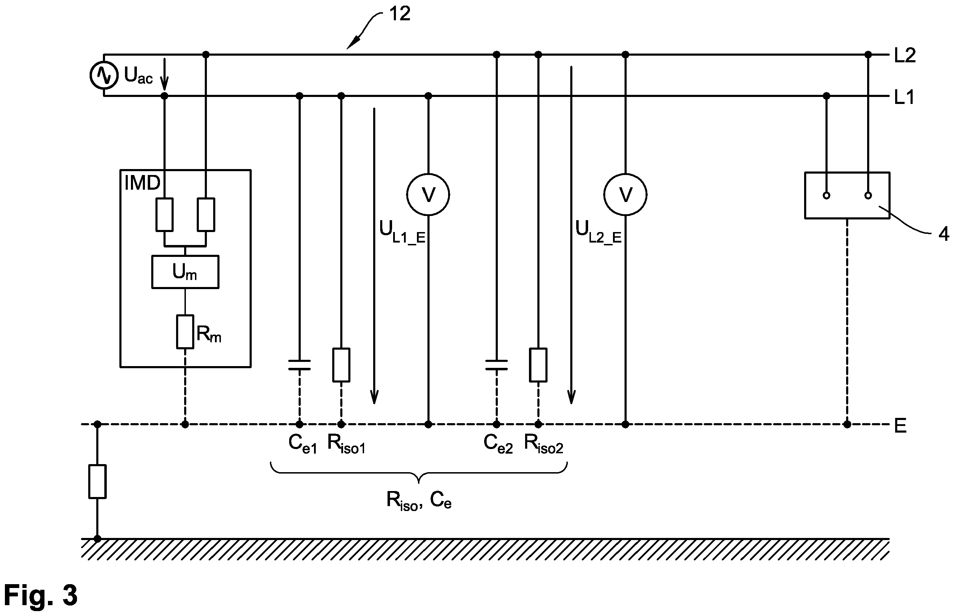

**Fig. 3** zeigt ein einphasiges Wechselstromstromversorgungssystem mit zwei aktiven Leitern L1, L2, an das eine Last 4 angeschlossen ist. Wie in dem in Fig. 1 beschriebenen Gleichspannungs-Stromversorgungssystem 12 findet auch hier eine Isolationsüberwachung mit Bestimmung des Gesamt-Isolationswiderstands $R_{iso}$ durch ein Isolationsüberwachungsgerät IMD statt. Um eine erfindungsgemäße Aufteilung des Gesamt-Isolationswiderstands $R_{iso}$ auf die den aktiven Leitern L1, L2 zugeordneten Teil-Isolationswiderstände $R_{iso1}$, $R_{iso2}$ durchführen zu können, werden Messungen der Verlagerungsspannungen $U_{L1\_E}$ und $U_{L2\_E}$ vorgenommen.

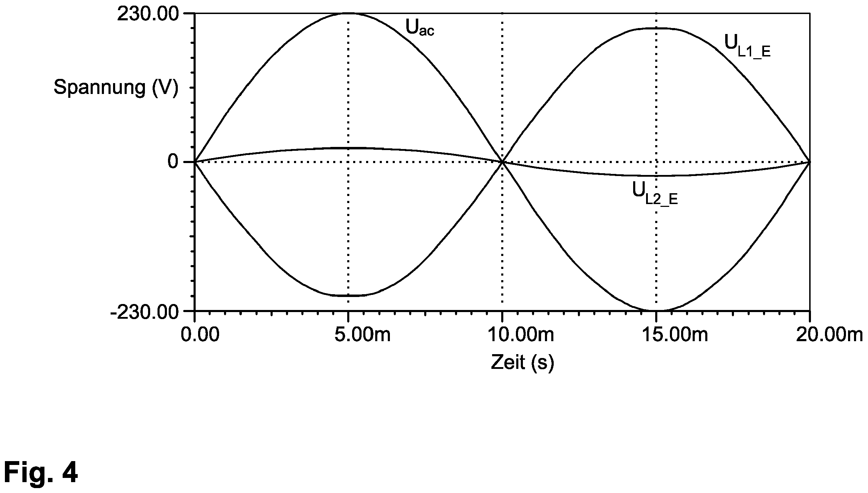

In **Fig. 4** sind die zeitlichen Verläufe der Leiter-Leiterspannung $U_{ac}$ (Einspeisespannung) und der an den jeweiligen aktiven Leitern $L_1$, $L_2$ messbaren Verlagerungsspannungen $U_{L1\_E}$ und $U_{L2\_E}$ dargestellt.

Im Gegensatz zu dem in Fig. 1 beschriebenen Gleichspannungs-Stromversorgungssystem 2 ist hier eine extern angeregte Änderung der Leiter-Leiter-Spannung $U_{ac}$, beispielsweise durch eine Laständerung, nicht erforderlich, da sich die Leiter-Leiter-Spannung $U_{ac}$ in einem Wechselspannungs-Stromversorgungssystem naturgemäß (sinusförmig) ändert. Basierend auf den Amplitudenänderungen der gemessenen Verlagerungsspannungen $U_{L1\_E}$ und $U_{L2\_E}$ sowie aufgrund der Phasenbeziehung zwischen den Verlagerungsspannungen $U_{L1\_E}$ und $U_{L2\_E}$ können die Aufteilungsfaktoren $r_R$ und rc bestimmt werden.

Die vorliegende Erfindung nutzt somit in vorteilhafter Weise die Tatsache aus, dass neben den von dem Isolationsüberwachungsgerät IMD zur Bestimmung des Gesamt-Isolationswiderstands $R_{iso}$ eingespeisten Gleichtaktmesssignals die Leiter-Leiter-Spannungen $U_{dc}$, $U_{ac}$, $U_{acxy}$ (Indizes x, y stehen für die aktiven Leiter x,y) zeitliche Änderungen aufweisen - verursacht durch externe Ereignisse wie beispielsweise Laständerungen oder implizit vorhanden sind, wie in Wechselspannungs-Stromversorgungssystemen - und die zeitliche Änderungen der erfassten Verlagerungsspannungen $U_{L+\_E}$, $U_{L-\_E}$, $U_{Lx\_E}$ bewirken.

Die Auswertung der Verlagerungsspannungen $U_{L+\_E}$, $U_{L-\_E}$, $U_{Lx\_E}$ hinsichtlich ihrer Amplitudenänderungen, ihrer Frequenz und ihrer Phasenlagen erlaubt es, Aussagen über die Aufteilung des Gesamt-Isolationswiderstandes $R_{iso}$ sowie der Gesamt-Netzableitkapazität $C_e$ auf die einzelnen aktiven Leiter $L_+$, $L_-$, $L_x$ zu gewinnen.

Vorteilhafterweise sind dazu keine weiteren hochgenauen Strommessungen erforderlich. Ebenso kann auf zusätzliche spannungsfeste Schalter zwischen den aktiven Leitern $L_+$, $L_-$, $L_x$ und Erde E verzichtet werden, die beispielsweise zum Ändern einer Ankoppelimpedanz des Isolationsüberwachungsgerätes IMD erforderlich wären, um die Verteilung des Gesamt-Isolationswiderstandes $R_{iso}$ oder der Gesamt-Netzableitkapazität $C_e$ ermitteln zu können.

**Patentansprüche**

1. Verfahren zur Bestimmung einer Aufteilung eines Gesamt-Isolationswiderstands ($R_{iso}$) in einem ungeerdeten ein- oder mehrphasigen AC-Stromversorgungssystem (12) mit aktiven Leitern ($L_x$), zwischen denen jeweils eine Leiter-Leiter-Spannung ($U_{ac}$, $U_{acxy}$) auftritt, umfassend die Verfahrensschritte:

- Bestimmen des Gesamt-Isolationswiderstands ($R_{iso}$) des ungeerdeten ein- oder mehrphasigen AC-Stromversorgungssystems (12),
- Messen von Verlagerungsspannungen ($U_{Lx\_E}$) zwischen jeweils einem der aktiven Leiter ($L_x$) des ungeerdeten ein- oder mehrphasigen AC-Stromversorgungssystems (12) und Erde (E),
- Ermitteln eines Widerstands-Aufteilungsfaktors ($r_R$), welcher die Aufteilung des Gesamt-Isolationswiderstands ($R_{iso}$) in auf die aktiven Leiter ($L_x$) bezogene Teil-Isolationswiderstände ($R_{isox}$) beschreibt, in Abhängigkeit von mindestens einem der Parameter Amplitude, Frequenz, Phase der gemessenen Verlagerungsspannungen ($U_{Lx\_E}$), wobei in dem ungeerdeten ein- oder mehrphasigen AC-Stromversorgungssystem (12) der Widerstands-Aufteilungsfaktor ($r_R$) aus einem Verhältnis der Amplituden der Verlagerungsspannungen ($U_{Lx\_E}$) unter Einbeziehung der Frequenz und der Phasenlagen der Verlagerungsspannungen ($U_{Lx\_E}$) ermittelt wird.

2. Verfahren zur Bestimmung einer Aufteilung einer Gesamt-Netzableitkapazität ($C_e$) in einem ungeerdeten Stromversorgungssystem (2, 12) mit aktiven Leitern ($L_+$, $L_-$, $L_x$), zwischen denen jeweils eine Leiter-Leiter-Spannung ($U_{dc}$, $U_{ac}$, $U_{acxy}$) auftritt, umfassend die Verfahrensschritte:

- Bestimmen der Gesamt-Netzableitkapazität ($C_e$) des ungeerdeten Stromversorgungssystems (2, 12),
- Messen von Verlagerungsspannungen ($U_{L+\_E}$, $U_{L-\_E}$, $U_{Lx\_E}$) zwischen jeweils einem der aktiven Leiter ($L_+$, $L_-$, $L_x$) und Erde (E),
- Ermitteln eines Kapazitäts-Aufteilungsfaktors ($r_C$), welcher die Aufteilung der Gesamt-Netzableitkapazität ($C_e$) in auf die aktiven Leiter ($L_+$, $L_-$, $L_x$) bezogene Teil-Netzableitkapazitäten ($C_{e+}$, $C_{e-}$, $C_{ex}$) beschreibt, in Abhängigkeit von mindestens einem der Parameter Amplitude, Frequenz, Phase der gemessenen Verlagerungsspannungen ($U_{L+\_E}$, $U_{L-\_E}$, $U_{Lx\_E}$).

3. Verfahren nach Anspruch 2,
**dadurch gekennzeichnet,**
**dass** in dem ungeerdeten DC-Stromversorgungssystem (2) der Kapazitäts-Aufteilungsfaktor ($r_C$) aus der Dauer eines durch die Amplitudenänderung der Leiter-Leiter-Spannung ($U_{dc}$) verursachten Einschwingvorgangs der jeweiligen Verlagerungsspannung ($U_{L+\_E}$, $U_{L-\_E}$, $U_{Lx\_E}$) ermittelt wird.

4. Verfahren nach Anspruch 2,
**dadurch gekennzeichnet,**
**dass** in dem ungeerdeten ein- oder mehrphasigen AC-Stromversorgungssystem (12) der Kapazitäts-Aufteilungsfaktor ($r_C$) aus dem Verhältnis der Amplituden der Verlagerungsspannungen ($U_{Lx\_E}$) unter Einbeziehung der Frequenz und der Phasenlagen der Verlagerungsspannungen ($U_{Lx\_E}$) ermittelt wird.

5. Vorrichtung, eingerichtet zur Durchführung eines Verfahrens zur Bestimmung einer Aufteilung eines Gesamt-Isolationswiderstands ($R_{iso}$) gemäß Anspruch 1 und eingerichtet zur Durchführung eines Verfahrens zur Bestimmung einer Aufteilung einer Gesamt-Netzableitkapazität ($C_e$) gemäß einem der Ansprüche 2 bis 4 in einem ungeerdeten Stromversorgungssystem (2, 12), bestehend aus einem normgemäßen Isolationsüberwachungsgerät zur Bestimmung des Gesamt-Isolationswiderstands ($R_{iso}$) und welches zur Bestimmung der Gesamt-Netzableitkapazität ($C_e$) ausgeführt ist,
die Vorrichtung weiter aufweisend Signaleingänge zum Messen von Verlagerungsspannungen ($U_{L+\_E}$, $U_{L-E}$, $U_{Lx\_E}$) zwischen jeweils einem der aktiven Leiter ($L_+$, $L_-$, $L_x$) und Erde (E), und Signalverarbeitungseinheiten zum Ermitteln, in Abhängigkeit von mindestens einem der Parameter Amplitude, Frequenz, Phase der gemessenen Verlagerungsspannungen ($U_{L+\_E}$, $U_{L-\_E}$, $U_{Lx\_E}$), eines Widerstands-Aufteilungsfaktors ($r_R$), welcher die Aufteilung des Gesamt-Isolationswiderstands ($R_{iso}$) in auf die aktiven Leiter ($L_+$, $L_-$, $L_x$) bezogene Teil-Isolationswiderstände ($R_{iso+}$, $R_{iso-}$ $R_{isox}$) beschreibt und zum Ermitteln, in Abhängigkeit von mindestens einem der Parameter Amplitude, Frequenz, Phase der gemessenen Verlagerungsspannungen ($U_{L+\_E}$, $U_{L-\_E}$, $U_{Lx\_E}$), eines Kapazitäts-Aufteilungsfaktors ($r_C$), welcher die Aufteilung der Gesamt-Netzableitkapazität ($C_e$) in auf die aktiven Leiter ($L_+$, $L_-$, $L_x$) bezogene Teil-Netzableitkapazitäten ($C_{e+}$, $C_{e-}$, $C_{ex}$) beschreibt.

## Claims

1. A method for determining a division of a total insulation resistance ($R_{iso}$) in an ungrounded single-phase or multiphase AC power supply system (12) comprising active conductors ($L_x$) between each of which a conductor-conductor voltage ($U_{ac}$, $U_{acxy}$) occurs, the method comprising the method steps of:

- determining the total insulation resistance ($R_{iso}$) of the ungrounded single-phase or multiphase AC power supply system (12),
- measuring displacement voltages ($U_{Lx\_E}$) between each of the active conductors ($L_x$) of the ungrounded single-phase or multiphase AC power supply system (12) and ground (E),

- determining a resistance division factor ($r_R$), which describes the division of the total insulation resistance ($R_{iso}$) into partial insulation resistances ($R_{isox}$) related to the active conductors ($L_x$), as a function of at least one of the parameters amplitude, frequency, phase of the displacement voltages ($U_{Lx\_E}$) measured ,

the resistance division factor ($r_R$) being determined from the relation of the amplitudes of the displacement voltages ($U_{Lx\_E}$) in an ungrounded single-phase or multi-phase AC power supply system (12), taking into account the frequency and the phasing of the displacement voltages ($U_{Lx\_E}$).

2. A method for determining a division of a total system leakage capacitance ($C_e$) in an ungrounded power supply system (2, 12) comprising active conductors ($L+$, $L$ , $L_x$) between each of which a conductor-conductor voltage ($U_{dc}$, $U_{ac}$, $U_{acxy}$) occurs, the method comprising the steps of:

> - determining the total system leakage capacitance ($C_e$) of the ungrounded power supply system (2, 12),
> - measuring displacement voltages ($U_{L+\_E}$, $U_{L-\_E}$, $U_{Lx\_E}$) between each of the active conductors ($L+$, $L$ , $L_x$) and ground (E),
> - determining a capacitance division factor (rc), which describes the division of the total system leakage capacitance ($C_e$) into partial system leakage capacitances ($C_{e+}$, $C_{e-}$, $C_{ex}$) related to the active conductors ($L+$, $L$ , $L_x$), as a function of at least one of the parameters amplitude, frequency, phase of the displacement voltages ($U_{L+\_E}$, $U_{L-\_E}$, $U_{Lx\_E}$) measured.

3. The method according to claim 2,
**characterized in that**
in the ungrounded DC power supply system (2), the capacitance division factor ($r_C$) is determined from the duration of a transient effect of the respective displacement voltage ($U_{L+\_E}$, $U_{L-\_E}$, $U_{Lx\_E}$) caused by the change in amplitude of the conductor-conductor voltage ($U_{dc}$).

4. The method according to claim 2,
**characterized in that**
in the ungrounded single-phase or multiphase AC power supply system (12), the capacitance division factor (rc) is determined from the relation of the amplitudes of the displacement voltages ($U_{Lx\_E}$), taking into account the frequency and the phasing of the displacement voltages ($U_{Lx\_E}$).

5. A device configured for implementing a method for determining a division of a total insulation resistance ($R_{iso}$) according to claim 1 and configured for implementing a method for determining a division of a total system leakage capacitance ($C_e$) according to claim 2 to 4 in an ungrounded power supply system (2, 12), the device consisting of a standard insulation monitoring device which serves to determine the total insulation resistance ($R_{iso}$) and which is configured for determining the total system leakage capacitance ($C_e$),
the device further comprising signal inputs for measuring displacement voltages ($U_{L+\_E}$, $U_{L-\_E}$, $U_{Lx\_E}$) between each of the active conductors ($L+$, $L_-$, $L_x$) and ground (E) and signal processing units for determining a resistance division factor ($r_R$) as a function of one of the parameters amplitude, frequency, phasing of the displacement voltages ($U_{L+\_E}$, $U_{L-\_E}$, $U_{Lx-E}$) measured, the resistance division factor ($r_R$) describing the division of the total insulation resistance ($R_{iso}$) into partial insulation resistances ($R_{iso+}$, $R_{iso-}$, $R_{isox}$) related to the active conductors ($L+$, $L_-$, $L_x$), and for determining a capacitance division factor (rc) as a function of one of the parameters amplitude, frequency, phasing of the displacement voltages ($U_{L+\_E}$, $U_{L-\_E}$, $U_{Lx-E}$) measured, the capacitance division factor (rc) describing the division of the total system leakage capacitance ($C_e$) into partial system leakage capacitances ($C_{e+}$, $C_{e-}$, $C_{ex}$) related to the active conductors ($L+$, $L$ , $L_x$).

**Revendications**

1. Procédé pour la détermination d'un partage d'une résistance d'isolement totale ($R_{iso}$) dans un système d'alimentation (12) en courant alternatif monophasé ou multiphasé non mis à la terre et comprenant des conducteurs actifs ($L_x$) entre chacun desquels une tension conducteur-conducteur ($U_{ac}$, $U_{acxy}$) se produit, le procédé comprenant les étapes suivantes :

> - la détermination de la résistance d'isolement totale ($R_{iso}$) du système d'alimentation (12) en courant alternatif monophasé ou multiphasé non mis à la terre,
> - la mesure des tensions résiduelles ($U_{Lx\_E}$) entre chacun des conducteurs actifs ($L_x$) du système d'alimentation (12) en courant alternatif monophasé ou multiphasé non mis à la terre et la terre (E),
> - la détermination d'un facteur de partage ($r_R$) de la résistance, qui décrit le partage de la résistance d'isolement totale ($R_{iso}$) en résistances d'isolement partielles ($R_{isox}$) liés aux conducteurs actifs ($L_x$), en fonction d'au moins un des paramètres amplitude, fréquence, phase des tensions résiduelles ($U_{Lx\_E}$) mesurées, le facteur de partage ($r_R$) de la résistance étant déterminé à partir d'une relation des amplitudes des tensions résiduelles ($U_{Lx\_E}$) dans un système d'alimentation (12) en courant alternatif monophasé ou multiphasé non mis à la terre, en tenant compte de la fréquence et de la mise en phase des tensions résiduelles ($U_{LX\_E}$).

2. Procédé pour la détermination d'un partage d'une capacité ($C_e$) de fuite de système totale dans un système d'alimentation (2, 12) non mis à la terre et comprenant des conducteurs actifs (L+, L-, $L_x$) entre chacun desquels une tension conducteur-conducteur (U, $U_{dcac}$, $U_{acxy}$) se produit, le procédé comprenant les étapes suivantes :

    - la détermination de la capacité ($C_e$) de fuite de système totale du système d'alimentation (2, 12) non mis à la terre,
    - la mesure des tensions résiduelles (U, $U_{L+\_EL-\_E}$, $U_{Lx\_E}$) entre chacun des conducteurs actifs (L+, L-, $L_x$) et la terre (E),
    - la détermination d'un facteur de partage (rc) de la capacité, qui décrit le partage de la capacité ($C_e$) de fuite de système totale en capacités ($C_{e+}$, $C_{e-}$, $C_{ex}$) de fuite de système partielles liées aux conducteurs actifs (L+, L-, $L_x$), en fonction d'au moins un des paramètres amplitude, fréquence, phase des tensions résiduelles ($U_{L+\_E}$, $U_{L-\_E}$, $U_{Lx\_E}$) mesurées.

3. Procédé selon la revendication 2,
**caractérisé en ce que**
dans le système d'alimentation (2) en courant continu non mis à la terre, le facteur de partage (rc) de la capacité est déterminé à partir de la durée d'un effet transitoire de la tension résiduelle ($U_{L+\_E}$, $U_{L-\_E}$, $U_{Lx\_E}$) respective causé par le changement d'amplitude de la tension conducteur-conducteur ($U_{dc}$).

4. Procédé selon la revendication 2,
**caractérisé en ce que**
dans le système d'alimentation (12) en courant alternatif monophasé ou multiphasé non mis à la terre, le facteur de partage (rc) de la capacité est déterminé à partir de la relation des amplitudes des tensions résiduelles ($U_{Lx\_E}$), en tenant compte de la fréquence et de la mise en phase des tensions résiduelles ($U_{\cdot Lx\_E}$).

5. Dispositif configuré pour la mise en oeuvre d'un procédé pour la détermination d'un partage de la résistance d'isolement totale ($R_{iso}$) selon la revendication 1 et configuré pour la mise en oeuvre d'un procédé pour la détermination d'un partage de capacité ($C_e$) de fuite de système totale selon la revendication 2 à 4 dans un système d'alimentation (2, 12) non mis à la terre, le dispositif consistant en un contrôleur d'isolement standard qui sert à déterminer la résistance d'isolement totale ($R_{iso}$) et qui est configuré pour la détermination de la capacité ($C_e$) de fuite de système totale,

le dispositif comprenant en outre des entrées de signal pour la mesure des tensions résiduelles ($U_{L+\_E}$, $U_{L-\_E}$, $U_{Lx\_E}$) entre chacun des conducteurs actifs (L+, L-, $L_x$) et la terre (E) et des unités de traitement du signal pour la détermination d'un facteur de partage ($r_R$) de la résistance en fonction de l'un des paramètres amplitude, fréquence, phase des tensions résiduelles ($U_{L+\_E}$, $U_{L-\_E}$, $U_{Lx\_E}$) mesurées, le facteur de partage ($r_R$) de la résistance décrivant le partage de la résistance d'isolement totale ($R_{iso}$) en résistances d'isolement partielles ($R_{iso+}$, $R_{iso-}$, $R_{isox}$) liées aux conducteurs actifs (L+, L-, $L_x$), et pour la détermination d'un facteur de partage (rc) de la capacité en fonction d'un des paramètres amplitude, fréquence, phase des tensions résiduelles (U, $U_{L+\_EL-\_E}$, $U_{Lx\_E}$) mesurées, le facteur de partage (rc) de la capacité décrivant le partage de la capacité ($C_e$) de fuite de système totale en capacités ($C_{e+}$, $C_{e-}$, $C_{ex}$) de fuite de système partielles liées aux conducteurs actifs (L+, L-, $L_x$).

**Fig. 1**

Fig. 2

**Fig. 3**

EP 3 598 151 B1

**Fig. 4**

EP 3 598 151 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102015008831 A1